# EUROPEAN PATENT SPECIFICATION

(11) **EP 2 581 925 B1**
(45) Date of publication and mention of the grant of the patent: **15.08.2018**
(21) Application number: 12174383.5
(22) Date of filing: 29.06.2012
(51) Int. Cl.: H01J 37/32, C23C 16/44, B01D 53/32, F01N 3/08, F01N 3/01

(54) **Plasma reactor for removal of contaminants**
Plasmareaktor zur Entfernung von Verunreinigungen
Réacteur à plasma pour l'élimination de contaminants

(30) Priority: 10.10.2011 KR 20110103085; 26.03.2012 KR 20120030687
(43) Date of publication of application: 17.04.2013
(73) Proprietor: Korea Institute of Machinery & Materials, Daejeon 305-343 (KR)
(72) Inventor: Hur, Min, Daejeon 305-343 (KR); Kang, Woo Seok, Daejeon 305-343 (KR); Lee, Jae Ok, Daejeon 305-343 (KR); Lee, Dae-Woon, Daejeon 305-343 (KR); Kim, Kwan-Tea, Daejeon 305-343 (KR); Song, Young Hoon, Daejeon 305-343 (KR)
(74) Representative: Delorme, Nicolas

(56) References cited:
- EP-A2- 2 312 612
- US-A1- 2004 037 756
- Jae Ok Lee ET AL: "Abatement of CF 4 and CHF 3 emitted from semiconductor manufacturing processes using low-pressure plasmas generated by annular-shaped electrodes", ISPC 20 Proceedings, 28 March 2011 (2011-03-28), pages 1-4, XP055115596, Retrieved from the Internet: URL:http://www.ispc-conference.org/ispcpro c/ispc20/490.pdf [retrieved on 2014-04-28]

## Description

### BACKGROUND OF THE INVENTION

### (a) Field of the Invention

The present invention relates to a plasma reactor for removing contaminants, and more particularly, to a plasma reactor for removing contaminants generated in a process chamber installed in a manufacturing line of semiconductor/thin film displays/solar cells.

### (b) Description of the Related Art

A process chamber for performing processes such as etching, deposition, cleaning, ashing, and nitriding treatment is installed in a manufacturing line of semiconductor/thin film displays/solar cells. The process chamber is connected to a vacuum pump to evacuate process gases. With the recent growth of the manufacturing industry of semiconductor/thin film displays/solar cells, the amount and types of contaminants generated in a process chamber are increasing.

Among them, CF₄, CHF₃, and SF₆ used for dry etching and fluorine-based gases, such as NF₃, used for a washing process, are kinds of greenhouse gas. Therefore, it is expected that there will be restrictions of emissions of these gases. Also, particulate materials to be emitted in etching/deposition/cleaning processes are accumulated on parts in the vacuum pump as time passes, and the durability and lifespan of the vacuum pump are reduced.

Accordingly, a plasma reactor is installed between the process chamber and the vacuum pump to remove contaminants emitted from the process chamber. A typical plasma reactor employs radio frequency (RF) and inductively coupled plasma.

An inductively coupled plasma reactor has a coil-shaped driving electrode outside a plasma generation space, and generates plasma by applying a voltage to both ends of the driving electrode. However, since the plasma reactor is expensive, in particular, a radio frequency (RF) power supply is very expensive, and power consumption for maintaining plasma is large, installation cost and maintenance cost are very high. Moreover, plasma may be non-uniformly generated inside the plasma generation space due to low discharge stability.

Other plasma reactors are described in the following documents: EP 2 312 612 and "Abatement of CF4 and CHF3 emitted from semiconductor manufacturing processes using low-pressure plasmas generated by annular-shaped electrodes" (Jae Ok Lee et al., ISPC 20 Proceedings). The above information disclosed in this Background section is only for enhancement of understanding of the background of the invention and therefore it may contain information that does not form the prior art that is already known in this country to a person of ordinary skill in the art.

### SUMMARY OF THE INVENTION

The present invention has been made in an effort to provide a plasma reactor for removal of contaminants, which is installed between a process chamber and a vacuum pump, having advantages of removing various types of contaminants generated in the process chamber in an effective manner because it has a simple structure and low installation cost and maintenance cost and is capable of a stable operation for a long period of time.

Furthermore, the present invention provides a plasma reactor for removal of contaminants, which removes contaminants better at a discharge side than at an intake side, and applies a uniform voltage across a driving electrode to generate uniform plasma inside a plasma generation space.

An exemplary embodiment of the present invention provides a plasma reactor for removal of contaminants, as defined in claim 1. The driving electrode may be disposed in an annular shape or a cylindrical shape on an outer peripheral surface of the dielectric body, and the driving electrode may be positioned at a distance from the first ground electrode and the second ground electrode along the lengthwise direction of the plasma reactor.

Alternatively, the driving electrode may include a first driving electrode and a second driving electrode that are disposed in an annular shape or a cylindrical shape on an outer peripheral surface of the dielectric body and positioned at a distance from each other. The first driving electrode and the second driving electrode may be respectively positioned at a distance from the first ground electrode and the second ground electrode along the lengthwise direction of the plasma reactor.

The first driving electrode and the second driving electrode may receive bipolar pulse voltages having the same level and opposite polarities.

Alternatively, the dielectric body may include a first dielectric body and a second dielectric body that are positioned at a distance from each other. The ground electrode may include a third ground electrode positioned between the first dielectric body and the second dielectric body and having a non-uniform diameter. The first dielectric body and the second dielectric body may have the same length and the same diameter.

The third ground electrode may include: a first variable diameter portion, which is fixed to the rear end of the first dielectric body and whose diameter gradually decreases along the flow direction of contaminants; and a second variable diameter portion, whose diameter gradually increases along the flow direction of contaminants and which is fixed to the front end of the second dielectric body. The first variable diameter portion and the second variable diameter portion may be varied in diameter at a fixed ratio, or have a staircase-like stepped part.

The ground electrode may include: a fourth ground electrode positioned at the front end of the first dielectric body and connecting the process chamber and the first dielectric body; and a fifth ground electrode positioned at the rear end of the second dielectric body and connecting the second dielectric body and the vacuum pump. The fourth ground electrode and the fifth ground electrode may have a constant diameter.

Alternatively, the fourth ground electrode may include: a uniform diameter portion having a smaller diameter than the first dielectric body; and a variable diameter portion, whose diameter gradually increases along the flow direction of contaminants and which is fixed to the front end of the first dielectric body. The fifth ground electrode may include: a variable diameter portion, which is fixed to the rear end of the second dielectric body and whose diameter gradually decreases along the flow direction of contaminants; and a uniform diameter portion having a smaller diameter than the second dielectric body.

The driving electrode may include: a third driving electrode disposed in an annular shape or a cylindrical shape on an outer peripheral surface of the first dielectric body; and a fourth driving electrode disposed in an annular shape or a cylindrical shape on an outer peripheral surface of the second dielectric body.

The third driving electrode and the fourth driving electrode may receive a bipolar pulse voltage having the same level and the same polarity. Alternatively, the third driving electrode and the fourth driving electrode may receive bipolar pulse voltages having the same level and opposite polarities.

Various types of contaminants generated in the process chamber are removed effectively because the installation cost and maintenance cost of the plasma reactor can be reduced and stable operation can be performed for a long period of time. Moreover, the ground electrode having a non-uniform diameter helps to improve plasma discharge efficiency, thereby reducing power consumption and improving the decomposition efficiency of contaminants.

Further, the plasma density at the center of the inside of the plasma reactor can be increased when contaminants are removed using low-pressure plasma, and this may lead to a reduction in the pressure dependence of the contaminant removal efficiency.

In addition, the first ground electrode has a uniform diameter, the second ground electrode has a non-uniform diameter, and the first distance between the driving electrode and the first ground electrode is set larger than the second distance between the driving electrode and the second ground electrode, so that the plasma discharge efficiency at the second electrode (i.e., discharge side) can be further improved, resulting in lower power consumption and higher decomposition efficiency of contaminants.

Further, a uniform voltage can be applied to the driving electrode along the lengthwise direction of the plasma reactor because the driving electrode is formed in a cylindrical (or annular) shape. Accordingly, uniform plasma can be generated along the lengthwise direction of the plasma reactor inside the plasma generation space.

### BRIEF DESCRIPTION OF THE DRAWINGS

Exemplary embodiments, including exemplary embodiments of the invention, will be described more fully hereinafter, with reference to the accompanying drawings in which corresponding reference symbols indicate corresponding parts, and in which:
FIG. 1 is a block diagram of a low-pressure process system including a plasma reactor according to an exemplary embodiment.
FIG. 2 is a perspective view of a plasma reactor according to a first exemplary embodiment.
FIG. 3 is a cross-sectional view of the plasma reactor taken along line I-I of FIG. 2.
FIG. 4 is a view showing a waveform example of the driving voltage applied to a driving electrode of the plasma reactor shown in FIG. 2.
FIG. 5 is a perspective view of a plasma reactor according to a second exemplary embodiment.
FIG. 6 is a cross-sectional view of a plasma reactor taken along line II-II of FIG. 5.
FIG. 7 is a view showing a waveform example of a first driving voltage and a second driving voltage respectively applied to the first driving electrode and second driving electrode of the plasma reactor shown in FIG. 5.
FIG. 8 is a perspective view of a plasma reactor according to a third exemplary embodiment.
FIG. 9 is a cross-sectional view of the plasma reactor taken along line III-III of FIG. 8.
FIG. 10 is a graph showing the comparison of the CF4 decomposition efficiency versus working pressure between the plasma reactor of the third exemplary embodiment and a plasma reactor of a comparative example.
FIG. 11 is a perspective view of a plasma reactor according to a fourth exemplary embodiment.
FIG. 12 is a cross-sectional view of the plasma reactor taken along line IV-IVof FIG. 11.
FIG. 13 is a perspective view of a plasma reactor according to a fifth exemplary embodiment.
FIG. 14 is a cross-sectional view of the plasma reactor taken along line V-V of FIG. 13.
FIG. 15 is a perspective view of a plasma reactor according to a sixth exemplary embodiment.
FIG. 16 is a cross-sectional view of the plasma reactor taken along line VI-VI of FIG. 15.

### DETAILED DESCRIPTION OF THE EMBODIMENTS

As those skilled in the art would realize, the described embodiments may be modified in various different ways, all without departing from the scope of the present invention.

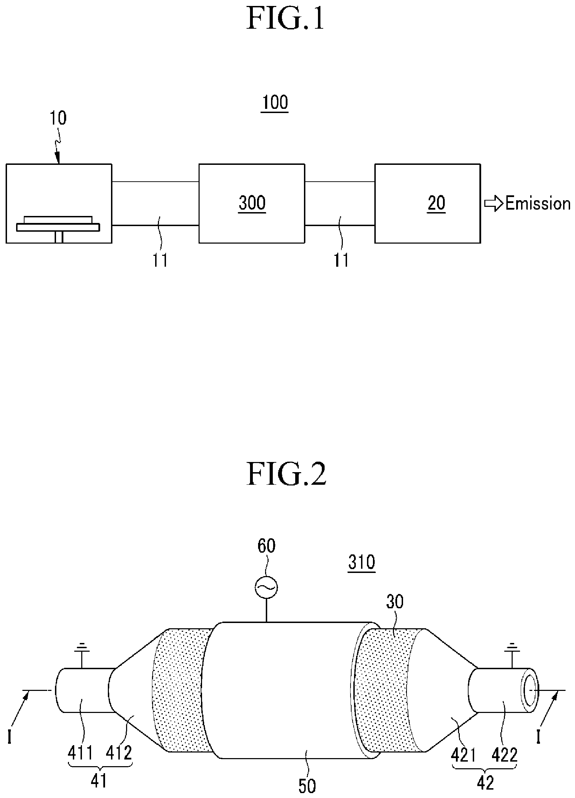

FIG. 1 is a block diagram of a low-pressure process system 100 including a plasma reactor 300 according to an exemplary embodiment of the present disclosure. The low-pressure process system of FIG. 1 is applied to a manufacturing process of semiconductor/thin film displays/solar cells.

Referring to FIG. 1, the low-pressure process system 100 includes a process chamber 10 for performing etching, deposition, cleaning, ashing, and nitriding treatment, a vacuum pump 20 installed behind the process chamber 10 to exhaust process gases from the process chamber 10, and a plasma reactor 300 positioned between the process chamber 10 and the vacuum pump 20. The plasma reactor 300 is connected to the process chamber 10 and the vacuum chamber 20, respectively, via two connecting tubes 11.

The plasma reactor 300 is installed in front of the vacuum pump 20, and the inside thereof maintains a low pressure state similar to the low pressure process chamber 10. The low pressure refers to, but is not limited to, a pressure within the range of approximately 0.01 Torr to 10 Torr (1.333 to 1333 Pa).

A reaction gas injection port (not shown) for injecting a reaction gas into the plasma reactor 300 may be positioned in front of the plasma reactor 300. The reaction gas may include at least one of O₂, H₂, and H₂O, and Ar may be used as a carrier gas for transferring the reaction gas. However, the reaction gas injection port is not a necessary component in the exemplary embodiment of the present disclosure, and may be omitted in practice.

The plasma reactor 300 generates low-pressure and high-temperature plasma therein to decompose contaminants (fluorine-based gases and particulate materials, such as organic metal compounds, metal oxides, and metal nitrides) emitted from the process chamber 10. The decomposed components chemically combine with the reaction gases and are changed into harmless elements. The plasma richly contains reactive species and high-energy electrons, which promote chemical reaction between the decomposed components of the contaminants and the reaction gases.

That is, the plasma reactor 300 decomposes greenhouse gases into non-greenhouse gases, and converts a particulate by-product into a gas or reduces the size of the particulate by-product to supply it to the vacuum pump 20. When treating greenhouse gases, greenhouse gases and oxygen are supplied to the plasma reactor 300. Oxygen or water may be additionally supplied to improve the treatment efficiency of greenhouse gases (not shown).

Plasma reactors 310, 320, 330, 340, 350, and 360 to be described hereinafter generate plasma by a capacitively coupled plasma method, include an AC power supply, and have an electrode structure for increasing discharge efficiency. In comparison with the inductively coupled plasma method, these characteristics help to reduce the installation cost and maintenance cost of plasma reactors and improve plasma discharge efficiency, thus improving the decomposition efficiency of contaminants and enabling stable operation for a long period of time.

Referring to FIG. 2 to FIG. 16, detailed structures and operations of plasma reactors according to first to sixth exemplary embodiments will be described.

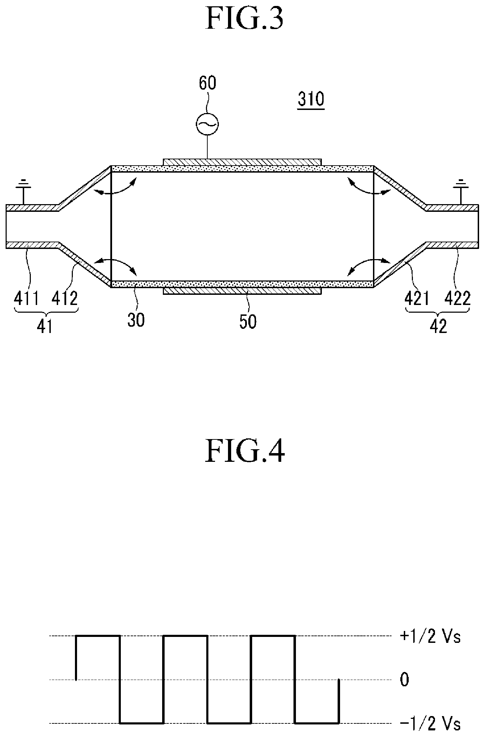

FIG. 2 is a perspective view of a plasma reactor 310 according to a first exemplary embodiment, and FIG. 3 is a cross-sectional view of the plasma reactor 310 taken along line I-I of FIG. 2.

Referring to FIG. 2 and FIG. 3, the plasma reactor 310 of the first exemplary embodiment includes a dielectric body 30 forming a plasma generation space inside the plasma reactor 310, a first ground electrode 41 connected to the front end of the dielectric body 30, a second ground electrode 42 connected to the rear end of the dielectric body 30, and a driving electrode 50 fixed to an outer peripheral surface of the dielectric body 30. The driving electrode 50 is connected to an AC power supply unit 60 to receive a driving voltage required for plasma discharge.

Basically, the dielectric body 30 and the driving electrode 50 are formed in the shape of a cylinder (or ring) having a constant diameter. On the other hand, the first ground electrode 41 and the second ground electrode 42 are formed to have a non-uniform diameter along the lengthwise direction (transverse direction in FIGS. 2 and 3) of the plasma reactor 310. At this point, the first ground electrode 41 and the second ground electrode 42 are bilaterally symmetrical with respect to the dielectric body 30.

The first ground electrode 41 includes a uniform diameter portion 411 having a smaller diameter than the dielectric body 30 and a variable diameter portion 412, whose diameter gradually increases along the flow direction (direction from the process chamber 10 toward the vacuum pump 20) of contaminants. The rear end of the variable diameter portion 412 is fixed to the front end of the dielectric body 30.

The second ground electrode 42 includes a variable diameter portion 421, whose diameter gradually decreases along the flow direction of contaminants, and a uniform diameter portion 422 having a smaller diameter than the dielectric body 30. The front end of the variable diameter portion 421 is fixed to the rear end of the dielectric body 30.

The variable diameter portions 412 and 421 may be varied in diameter at a fixed ratio, or have a staircase-like stepped part. The former case is illustrated in FIGS. 2 and 3.

The first and second ground electrodes 41 and 42 are made of a metal such as stainless steel. The first ground electrode 41 may be a connecting tube for connecting the process chamber 10 and the dielectric body 30, and the second ground electrode 42 may be a connecting tube for connecting the dielectric body 30 and the vacuum pump 20. The first ground electrode 41, the dielectric body 30, and the second ground electrode 42 constitute a tube extending in one direction to connect the process chamber 10 and the vacuum chamber 20.

The plasma reactor 310 having the above-stated structure may be easily installed on a vacuum pipeline between the process chamber 10 and the vacuum pump 20 which are already installed in a manufacturing line of semiconductor/thin film displays/solar cells.

The driving electrode 50 is disposed in an annular shape or a cylindrical shape at the center of the dielectric body 30, and is shorter in length than the dielectric body 30 and is positioned at a distance from the first and second ground electrodes 41 and 42 along the lengthwise direction of the plasma reactor 310. The driving electrode 50 may be positioned at an equal distance from the first and second ground electrodes 41 and 42. The driving electrode 50 is connected to the AC power supply unit 60 and applied with a high voltage having a frequency of several kHz to several hundreds of kHz (e.g., 1 kHz to 999 kHz).

FIG. 4 is a view showing a waveform example of the driving voltage applied to the driving electrode 50 of the plasma reactor 310 shown in FIG. 2.

Referring to FIG. 4, the driving voltage Vs applied to the driving electrode is a high voltage having a frequency of 1 kHz to 999 kHz, and the operating voltage periodically changes between a positive value (1/2Vs) and a negative value (-1/2Vs). Although FIG. 4 has been illustrated with respect to a rectangular waveform, a variety of waveforms, such as a triangular waveform, a sine waveform, etc., may be applied.

Referring again to FIGS. 2 and 3, when a driving voltage is applied to the driving electrode 50, a plasma discharge is induced into the inside of the plasma reactor 310 by the difference in voltage between the driving electrode 50 and the first and second ground electrodes 41 and 42. The discharge is generated when the operating voltage is higher than a breakdown voltage of internal gas, and the discharge current is continuously increased over time and then reduced with the increased amount of wall charges accumulated on the dielectric body 30.

That is, the spatial charges in the plasma are accumulated on the dielectric 30 to generate wall charges as the discharge current is increased after the discharge starts. The wall charges serve to suppress the voltage applied from the outside and the discharge becomes weak over time by the wall voltage of the dielectric body 30. The plasma discharge repeats the generation, sustain, and erase processes while the applied voltage is maintained.

Therefore, the discharge does not make a transition to arcing and removes contaminants generated in the process chamber 10 while staying in the glow area. When the discharge makes a transition to arcing, the discharge is concentrated in a narrow area, which causes damage to the electrodes. However, the plasma reactor 310 according to the first exemplary embodiment uses the wall charges of the dielectric body 30 to prevent the discharge from making a transition to arcing, thereby making it possible to expand the lifespan of the driving electrode 50 and the ground electrodes 41 and 42.

As the first and second ground electrodes 41 and 42 form the variable diameter portions 412 and 421, the discharge path is shortened when plasma discharge is induced by the difference in voltage between the driving electrode 50 and the first and second ground electrodes 41 and 42. That is, the variable diameter portions 412 and 421 of the first and second ground electrodes 41 and 42 exhibit a similar effect to that of an opposed discharge. Accordingly, a stronger plasma discharge is generated under the same power consumption condition, thereby improving plasma discharge efficiency.

The improved plasma discharge efficiency leads to improved contaminant treatment efficiency. The contaminant treatment efficiency is defined as "decomposition rate/power consumption," and a larger amount of contaminants can be treated under the same power consumption condition. An AC power supply constituting the AC power supply unit 60 is cheaper than the existing radio frequency power supply, thereby saving the installation cost and maintenance cost of the plasma reactor 310.

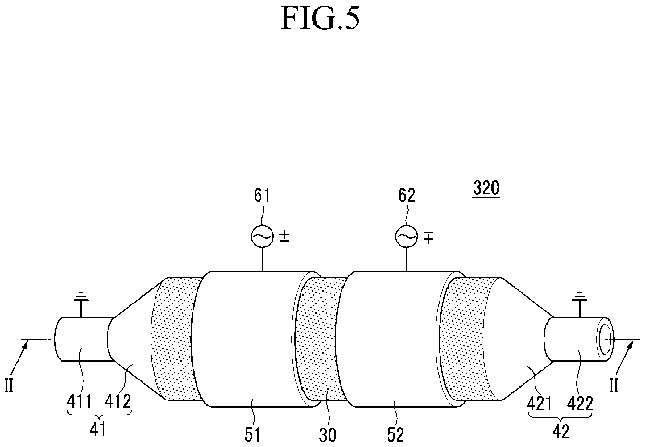

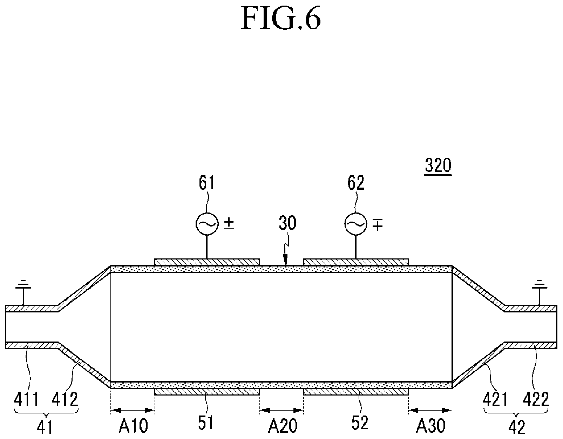

FIG. 5 is a perspective view of a plasma reactor 320 according to a second exemplary embodiment, and FIG. 6 is a cross-sectional view of the plasma reactor 320 taken along line II-II of FIG. 5.

Referring to FIG. 5 and FIG. 6, the plasma reactor 320 according to the second exemplary embodiment has the same configuration as the above-stated plasma reactor of the first exemplary embodiment, except that a first driving electrode 51 and a second driving electrode 52 are disposed on an outer peripheral surface of the dielectric body 30. The same reference numerals refer to the same members as the first exemplary embodiment, and components different from those of the first exemplary embodiment will be mainly described below.

The first driving electrode 51 and the second driving electrode 52 are disposed in an annular shape or a cylindrical shape on the outer peripheral surface of the dielectric body 30, and are positioned at a distance from each other along the lengthwise direction of the plasma reactor 320. The first and second driving electrodes 51 and 52 may have the same length. The distance between the first ground electrode 41 and the first driving electrode 51, the distance between the first driving electrode 51 and the second driving electrode 52, and the distance between the second driving electrode 52 and the second ground electrode 42 may be the same.

The first driving electrode 51 and the second driving electrode 52 are respectively connected to a first AC power supply unit 61 and a second AC power supply unit 62 to receive a driving voltage required for plasma discharge. The first and second driving electrodes 51 and 52 receive bipolar pulse voltages having the same level (amplitude) and opposite polarities. That is, AC voltages applied to the first and second driving electrodes 51 and 52 have a phase difference of 180° with respect to each other.

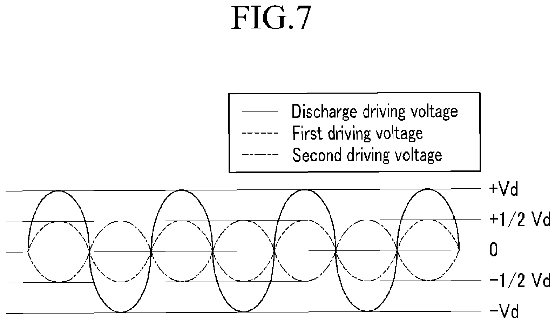

FIG. 7 is a view showing a waveform example of a first driving voltage and a second driving voltage respectively applied to the first driving electrode 51 and second driving electrode 52 of the plasma reactor 320 shown in FIG. 5.

Referring to FIG. 7, the first driving voltage and the second driving voltage have a phase difference of 180° with respect to each other, and alternately receive a positive voltage (+1/2 Vd) and a negative voltage (-1/2 Vd) at each period. The amplitude of the first and second driving voltages has a value corresponding to half the amplitude of the discharge driving voltage Vd. In this case, the "discharge driving voltage" is defined as a driving voltage that initiates discharge and maintains it, and may be set to a variety of values according to the shape condition of the plasma reactor and the state of the contaminants.

The discharge driving voltage Vd has the same phase as any one of the first driving voltage and the second driving voltage. The first and second driving voltages are high voltages of several hundred to several thousand volts, and have a frequency of several kHz to several hundreds of kHz. The first and second driving voltages may have various shapes such as a sine waveform, a rectangular waveform, a triangular waveform, etc. FIG. 7 illustrates an example in which the first and second driving voltages have a sine waveform.

Referring again to FIG. 5 and FIG. 6, the dielectric body 30 of the plasma reactor 320 includes a first dielectric area A10 between the first ground electrode 41 and the first driving electrode 51, a second dielectric area A20 between the first driving electrode 51 and the second driving electrode 52, and a third dielectric area A30 between the second driving electrode 52 and the second ground electrode.

When a positive or negative peak voltage is applied to the first driving electrode 51, and a negative or positive peak voltage is applied to the second driving electrode 52, a voltage corresponding to a difference between the first driving voltage and the second driving voltage, i.e., a voltage having the same level as the discharge driving voltage Vd, is applied to the second dielectric area A20. A voltage having the same level as the first driving voltage is applied to the first dielectric area A10, and a voltage having the same level as the second driving voltage is applied to the third dielectric area A30.

The discharge driving voltage Vd applied to the second dielectric area A20 is two times the driving voltages (+1/2Vd and -1/2Vd) respectively applied to the first and second driving electrodes 51 and 52. Thereby, stronger plasma is generated in the second dielectric area A20, i.e., at the center of the inside of the dielectric body 30, than in the first and third dielectric areas A10 and A30.

As a result, the plasma reactor 320 of the second exemplary embodiment suppresses plasma formed around the first and second ground electrodes 41 and 42 while improving the decomposition efficiency of contaminants, thereby minimizing the effect of plasma inside the plasma reactor 320 on the process chamber 10 or the vacuum pump 20.

Moreover, the plasma reactor 320 of the second exemplary embodiment can reduce the power consumption required for contaminant removal in an effective manner by lowering the ineffective power consumed in a circuit of the AC power supply unit. Moreover, since plasma is generated across the first to third dielectric areas A10, A20, and A30, the decomposition efficiency of contaminants can be improved by increasing the residual time of the contaminants in the plasma.

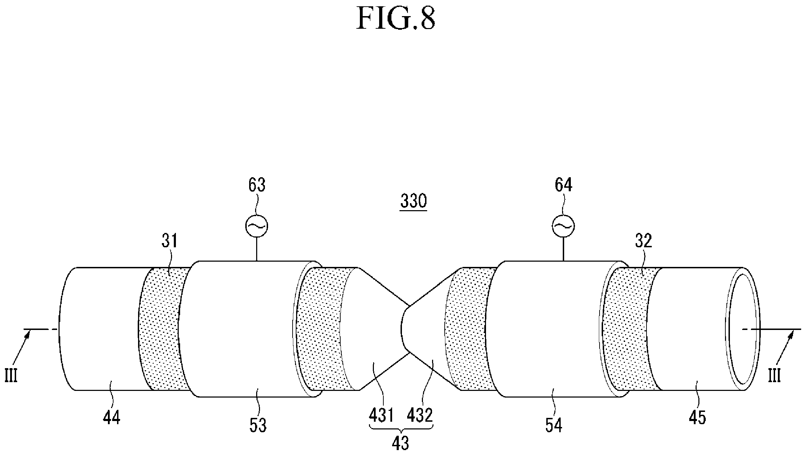

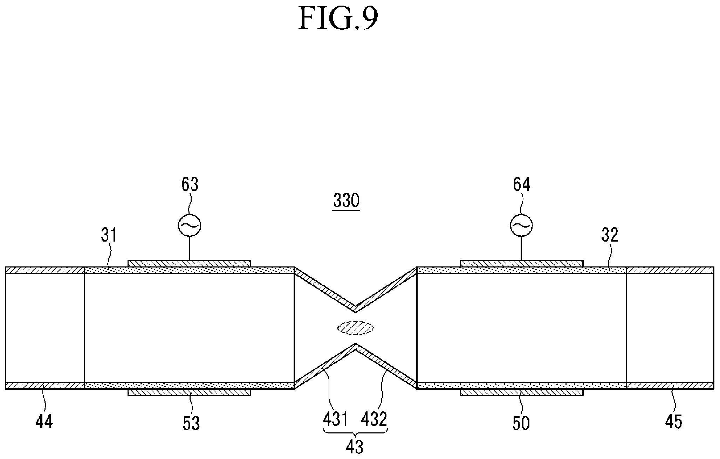

FIG. 8 is a perspective view of a plasma reactor 330 according to a third exemplary embodiment, and FIG. 9 is a cross-sectional view of the plasma reactor 330 taken along line III-III of FIG. 8.

Referring to FIG. 8 and FIG. 9, the plasma reactor 330 of the third exemplary embodiment has a basic configuration in which a dielectric body is divided into a first dielectric body 31 and a second dielectric body 32, and a third ground electrode 43 having a non-uniform diameter is positioned between the divided first and second dielectric bodies 31 and 32. The first dielectric body 31 and the second dielectric body 32 have the same length and the same diameter, and are positioned at a distance from each other along the lengthwise direction of the plasma reactor 330.

The first dielectric body 31 may be connected directly to the process chamber 10, or a fourth ground electrode 44 may be positioned at the front end of the first dielectric body 31. The fourth ground electrode 44 may be a connecting tube that connects the process chamber 10 and the first dielectric body 31. Likewise, the second dielectric body 32 may be connected directly to the vacuum pump 20, or a fifth ground electrode 45 may be positioned at the rear end of the dielectric body 32. The fifth ground electrode 45 may be a connecting tube that connects the second dielectric body 32 and the vacuum pump 20. The fourth ground electrode 44 and the fifth ground electrode 45 have the same diameter.

The third ground electrode 43 includes a first variable diameter portion 431, whose diameter gradually decreases along the flow direction of contaminants, and a second variable diameter portion 432, whose diameter gradually increases along the flow direction of contaminants. The front end of the first variable diameter portion 431 is connected to the rear end of the first dielectric body 31, and the rear end of the second variable diameter portion 432 is connected to the front end of the second dielectric body 32.

The first variable diameter portion 431 and the second variable diameter portion 432 may have a bilaterally symmetrical structure because they have the same length. The first and second variable diameter portions 431 and 432 may be varied in diameter at a fixed ratio, or may have a staircase-like stepped part. The former case is illustrated in FIGS. 8 and 9.

A driving electrode includes a third driving electrode 53 disposed in an annular shape or a cylindrical shape on an outer peripheral surface of the first dielectric body 31, and a fourth driving electrode 54 disposed in an annular shape or a cylindrical shape on an outer peripheral surface of the second dielectric body 32. The third driving electrode 53 is positioned at a distance from the third ground electrode 43 and the fourth ground electrode 44 along the lengthwise direction of the plasma reactor 330. Likewise, the fourth driving electrode 54 is positioned at a distance from the third ground electrode 43 and the fifth ground electrode 45 along the lengthwise direction of the plasma reactor 330. The third driving electrode 53 and the fourth driving electrode 54 may have the same length.

The third driving electrode 53 and the fourth driving electrode 54 are respectively connected to a third AC power supply unit 63 and a fourth AC power supply unit 64 to receive a driving voltage (high voltage having a frequency of several kHz to several hundred kHz) required for plasma discharge. The third and fourth driving electrodes 53 and 54 may receive an AC voltage (see FIG. 4) having the same level and polarity, or bipolar pulse voltages having the same level and opposite polarities. The advantage of the second driving method is identical to that explained in the second exemplary embodiment, so a detailed description thereof will be omitted.

The plasma reactor 330 of the third exemplary embodiment has a structure in which an electrode (third driving electrode 53) having a larger diameter, an electrode (third ground electrode 43) having a smaller diameter, and an electrode (fourth driving electrode 54) having a larger diameter are alternately disposed along the lengthwise direction. With this structure, the plasma density at the center of the inside of the third ground electrode 43 can be improved, thereby making it possible to reduce the pressure dependence of the contaminant removal efficiency.

In the case of a conventional plasma reactor having a plurality of electrodes having the same diameter disposed in a row, the contaminant removal efficiency varies significantly depending on working pressure. Specifically, as the working pressure of the plasma reactor rises, the number of high-energy electrons at the center of the plasma reactor tends to increase and the intensity of oxygen radicals tends to decrease.

The high-energy electrons generated by plasma discharge collide mainly with contaminants and function to decompose the contaminants, and the oxygen radicals chemically react mainly with the decomposed components and function to convert them into nonhazardous atoms. Accordingly, as the working pressure of the conventional plasma reactor rises, the decomposition efficiency of the contaminants drops sharply.

However, the plasma reactor 330 of the third exemplary embodiment makes it possible to increase the plasma density, i.e., the number of high-energy electrons and the intensity of oxygen radicals, at the center of the inside of the third ground electrode 43, by narrowing the diameter of the center of the third ground electrode 43. Accordingly, variations in contaminant removal efficiency depending on pressure, that is, pressure dependence, can be reduced.

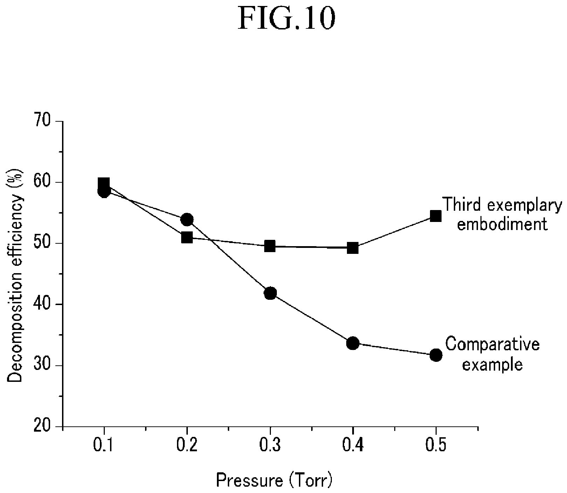

FIG. 10 is a graph showing the comparison of the CF4 decomposition efficiency versus working pressure between the plasma reactor of the third exemplary embodiment and a plasma reactor of a comparative example.

The plasma reactor of the comparative example is configured by modifying the plasma reactor of the second exemplary embodiment shown in FIG. 5 such that the first ground electrode and the second ground electrode have the same diameter as the dielectric body. The plasma reactor of the comparative example and the plasma reactor of the third exemplary embodiment have the same test conditions, and a 3kV voltage with a frequency of 100 kHz was applied at 800 W of power to the driving electrodes. Moreover, CF₄ gas (50 sccm) as a contaminant, O₂ gas (50 sccm) as a reaction gas, and Ar gas (50 sccm) as a carrier gas were injected.

Referring to FIG. 10, as the working pressure of the plasma reactor of the comparative example increases, the CF₄ decomposition efficiency drops sharply from around 60 % to around 30 %. On the other hand, the CF₄ decomposition efficiency of the plasma reactor of the third exemplary embodiment slowly changes from around 60 % to around 50 %. Therefore, it is confirmed that the pressure dependence of the contaminant decomposition efficiency was significantly reduced.

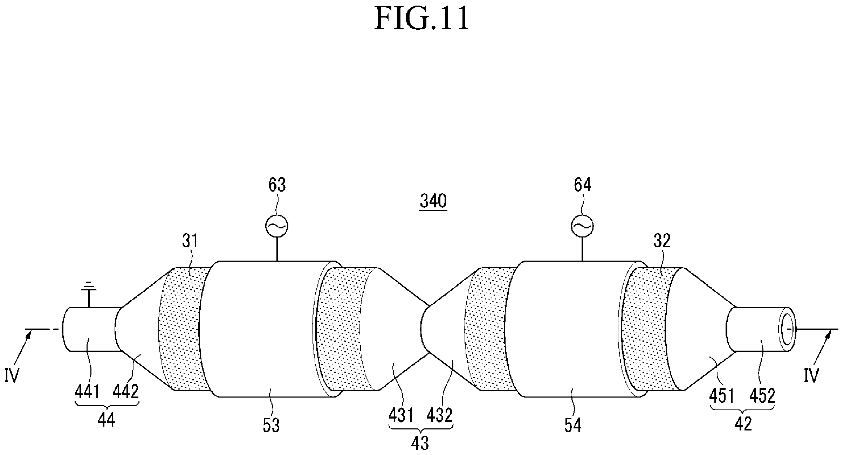

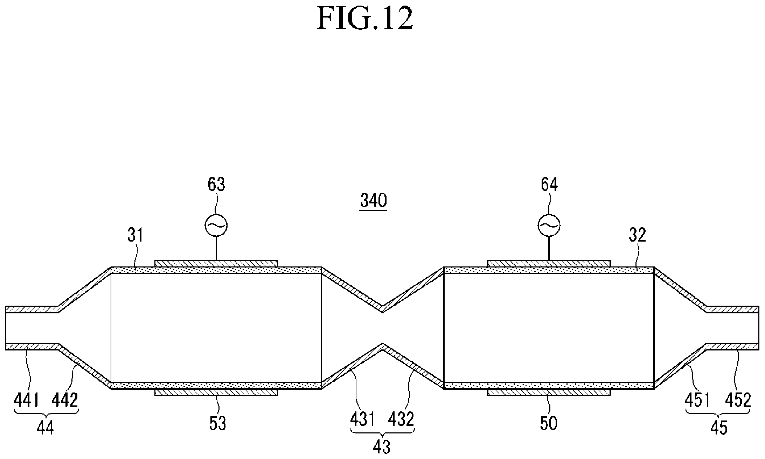

FIG. 11 is a perspective view of a plasma reactor 340 according to a fourth exemplary embodiment, and FIG. 12 is a cross-sectional view of the plasma reactor 340 taken along line IV-IV of FIG. 11.

Referring to FIG. 11 and FIG. 12, the plasma reactor of the fourth exemplary embodiment has the same configuration as the above-stated plasma reactor of the third exemplary embodiment, except that the fourth ground electrode 44 and the fifth ground electrode 45 include variable diameter portions 442 and 451, respectively. The same reference numerals refer to the same members as the third exemplary embodiment, and components different from those of the third exemplary embodiment will be mainly described below.

The fourth ground electrode 44 includes a uniform diameter portion 441 having a smaller diameter than the first dielectric body 31, and a variable diameter portion 442, whose diameter gradually increases along the flow direction of contaminants. The rear end of the variable diameter portion 442 is fixed to the front end of the first dielectric body 31. The fifth ground electrode 45 includes a variable diameter portion 451, whose diameter gradually decreases along the flow direction of contaminants, and a uniform diameter portion 452 having a smaller diameter than the second dielectric body 32. The front end of the variable diameter portion 451 is fixed to the rear end of the second dielectric body 32.

The variable diameter portions 442 and 451 may be varied in diameter at a fixed ratio, or have a staircase-like stepped part. The former case is illustrated in FIGS. 11 and 12.

The variable diameter portions 442 and 451 of the fourth and fifth ground electrodes 44 and 45 cause the discharge path to be shortened when plasma discharge is induced by the difference in voltage between the driving electrodes 53 and 54 and the ground electrodes 43, 44, and 45, thereby improving plasma discharge efficiency. Accordingly, a stronger plasma discharge is generated under the same power consumption conditions, thereby improving the treatment efficiency of contaminants.

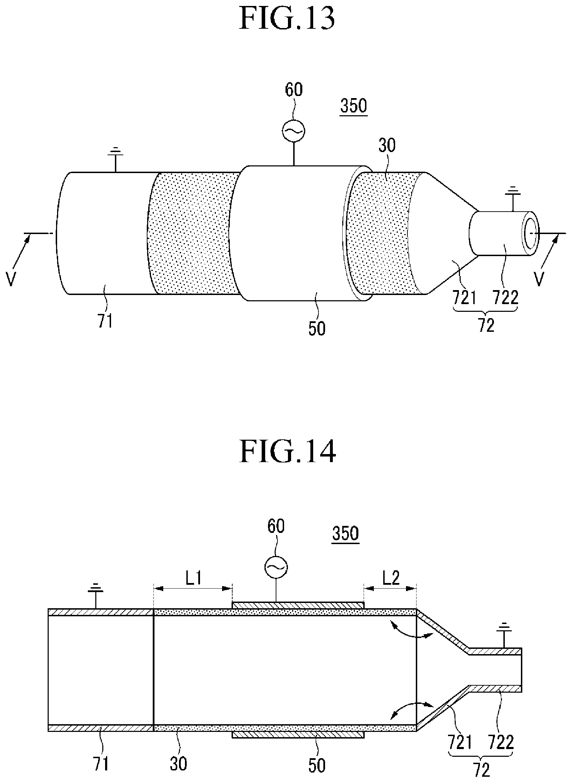

FIG. 13 is a perspective view of a plasma reactor 350 according to a fifth exemplary embodiment, and FIG. 14 is a cross-sectional view of the plasma reactor 350 taken along line V-V of FIG. 13.

Referring to FIG. 13 and FIG. 14, the plasma reactor 350 of the fifth exemplary embodiment includes a dielectric body 30 forming a plasma generation space inside the plasma reactor 350, a first ground electrode 71 connected to the front end of the dielectric body 30, a second ground electrode 72 connected to the rear end of the dielectric body 30, and a driving electrode 50 fixed to an outer peripheral surface of the dielectric body 30. The driving electrode 50 is connected to an AC power supply unit 60 to receive a driving voltage required for plasma discharge.

Basically, the dielectric body 30, the driving electrode 50, and the first ground electrode 71 are formed in the shape of a cylinder (or ring) having a constant diameter. On the other hand, the second ground electrode 72 is formed to have a non-uniform diameter along the lengthwise direction (transverse direction in FIGS. 13 and 14) of the plasma reactor 350. At this point, the first ground electrode 71 and the second ground electrode 72 are bilaterally symmetrical with respect to the dielectric body 30.

The first ground electrode 71 has a uniform diameter along the flow direction of contaminants, which is equal to the diameter of the dielectric body 30. The rear end of the first ground electrode 71 is fixed to the front end of the dielectric body 30.

The second ground electrode 72 includes a variable diameter portion 721, whose diameter gradually decreases along the flow direction of contaminants, and a uniform diameter portion 722 having a smaller diameter than the dielectric body 30. The front end of the variable diameter portion 721 is fixed to the rear end of the dielectric body 30.

The variable diameter portion 721 may be varied in diameter at a fixed ratio, or have a staircase-like stepped part.

The first and second ground electrodes 71 and 72 are made of a metal such as stainless steel. The first ground electrode 71 may be a connecting tube for connecting the process chamber 10 and the dielectric body 30, and the second ground electrode 72 may be a connecting tube for connecting the dielectric body 30 and the vacuum pump 20. The first ground electrode 71, the dielectric body 30, and the second ground electrode 72 constitute a tube extending in one direction to connect the process chamber 10 and the vacuum chamber 20.

The plasma reactor 350 having the above-stated structure may be easily installed on a vacuum pipeline between the process chamber 10 and the vacuum pump 20 which are already installed in a manufacturing line of semiconductor/thin film displays/solar cells.

Since the driving electrode 50 is disposed in a cylindrical (or ring) shape at the center of the dielectric body 30, a uniform voltage is received across the entire range of the driving electrode 50 along the flow direction of contaminants. Accordingly, plasma is uniformly generated inside the plasma generation space.

The driving electrode 50 has a smaller length than the dielectric body 30, and is positioned at a distance from the first and second ground electrodes 71 and 72 along the lengthwise direction of the plasma reactor 350. That is, the driving electrode 50 may be positioned at a first distance L1 and a second distance L2, respectively, from the first and second ground electrodes 71 and 72.

The first distance L1 is set between the front end of the driving electrode 50 and the first ground electrode 71, and the second distance L2 is set between the rear end of the driving electrode 50 and the second ground electrode 72. The first distance L1 is longer than the second distance L2. That is, the driving electrode 50 is disposed towards the second ground electrode 72.

The driving electrode 50 is connected to the AC power supply unit 60 to receive a high voltage having a frequency of several kHz to several hundreds of kHz (e.g., 1 kHz to 999 kHz). For example, the driving voltage having the waveform shown in FIG. 4 may be applied.

Referring again to FIG. 13 and FIG. 14, since the driving electrode 50 is disposed towards the second ground electrode 72, rather than towards the first ground electrode 71 (L1>L2), stronger plasma discharge is generated at the second ground electrode 72 than at the first ground electrode 71. Accordingly, untreated contaminants within the discharge space may be further treated at the second ground electrode 72.

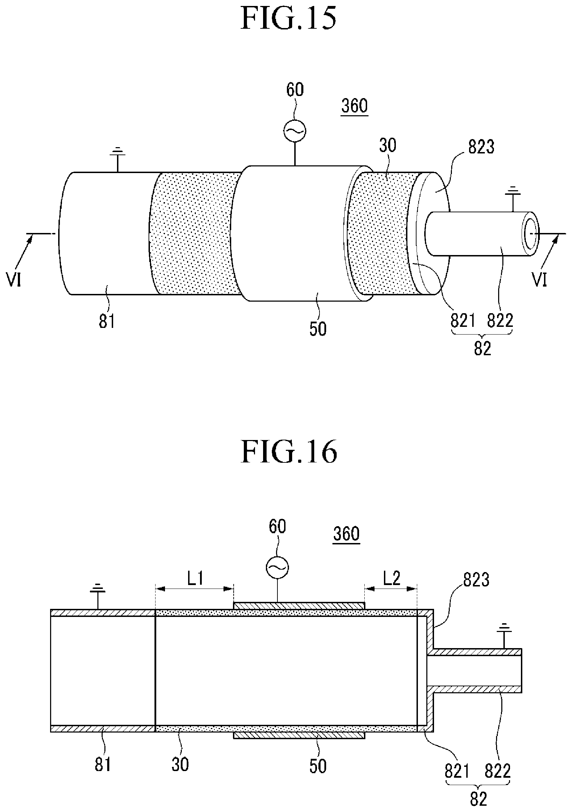

FIG. 15 is a perspective view of a plasma reactor 360 according to a sixth exemplary embodiment, and FIG. 16 is a cross-sectional view of the plasma reactor 360 taken along line VI-VI of FIG. 15.

Referring to FIG. 15 and FIG. 16, the plasma reactor 360 according to the sixth exemplary embodiment has the same configuration as the fifth exemplary embodiment, except for the second ground electrode 82 disposed at the rear end of the dielectric body 30, which is different from the second ground electrode 72 of the fifth exemplary embodiment. The same reference numerals refer to the same members as the fifth exemplary embodiment, and components different from those of the fifth exemplary embodiment will be mainly described below.

A first ground electrode 81 is fixed to the front end of the dielectric body 30, and has the same diameter as the dielectric body 30. A second ground electrode 82 is fixed to the rear end of the dielectric body 30, and includes a large diameter portion 821 having the same diameter as the dielectric body 30 and a small diameter portion 822 connected to the large diameter portion 821 and having a smaller diameter than the large diameter portion 821.

The first distance L1 is set between the front end of the driving electrode 50 and the first ground electrode 81, and the second distance L2 is set between the rear end of the driving electrode 50 and the second ground electrode 82. The first distance L1 is longer than the second distance L2. That is, the driving electrode 50 is disposed towards the large diameter portion 821 of the second ground electrode 82.

Since the driving electrode 50 is disposed towards the large diameter portion 821 of the second ground electrode 82, rather than towards the first ground electrode 81 (L1 >L2), stronger plasma discharge is generated at the large diameter portion 821 of the second ground electrode 82 than at the first ground electrode 81. Accordingly, untreated contaminants within the discharge space may be further treated at the large diameter portion 821 of the second ground electrode 82.

Further, the second ground electrode 82 also includes a sidewall portion 823 connecting the large diameter portion 821 and the small diameter portion 822. The sidewall portion 823 exhibits a similar effect to that of opposed discharge with the driving electrode 50.

That is, discharge between the sidewall portion 823 and the driving electrode 50 in the sixth exemplary embodiment is closer to opposed discharge than discharge between the variable diameter portion 721 and the driving electrode in the fifth exemplary embodiment. Accordingly, the second ground electrode 82 of the sixth exemplary embodiment can generate stronger plasma discharge than the second ground electrode 72 of the fifth exemplary embodiment, thereby further improving plasma discharge efficiency.

The plasma reactors 310, 320, 330, 340, 350, and 360 of the foregoing exemplary embodiments commonly include a dielectric body, a ground electrode connected to one end of the dielectric body, and a driving electrode fixed to an outer peripheral surface of the dielectric body and receiving an AC driving voltage. The ground electrode has a non-uniform diameter along the lengthwise direction of the plasma reactors, and therefore causes the discharge path to be shortened, thereby improving plasma discharge efficiency or reducing the pressure dependence of contaminant removal efficiency.

While this invention has been described in connection with what is presently considered to be practical exemplary embodiments, it is to be understood that the invention is not limited to the disclosed embodiments, but, on the contrary, is intended to cover various modifications and equivalent arrangements included within the scope of the appended claims. The invention is defined by the claims.

### <Description of Symbols>

| | |
|---|---|
| 10: process chamber | 11: connecting tube |
| 12: vacuum pump | 100: low-pressure process system |
| 300, 310, 320, 330, 340, 350, 360: plasma reactor | |
| 30: dielectric body | 31: first dielectric body |
| 32: second dielectric body | |
| 41, 42, 43, 44, 45: first to fifth ground electrodes | |
| 50: driving electrode | |
| 51, 52, 53, 54: first to fourth electro des | |
| 60: AC power supply unit | |
| 61, 62, 63, 64: first to fourth AC po wer supply units | |
| 71: first ground electrode | 72, 82: second ground electrode |
| 721: variable diameter portion | 722: uniform diameter portion |
| 821, 822: large and small diameter portions | |
| 823: sidewall portion | |
| L1, L2: first and second distances | |

## Claims

1. A plasma reactor for removal of contaminants, for being positioned between a process chamber (10) and a vacuum pump (20), and arranged to generate low-pressure plasma to remove contaminants emitted from the process chamber (10), the plasma reactor (300, 310, 320, 330, 340, 350, 360) comprising: an AC power supply unit (60, 61, 62, 63, 64); at least one dielectric body (30) arranged to form a plasma generation space therein; the dielectric body being disposed at the center of the plasma reactor;
a ground electrode comprising a first ground electrode (41, 71, 81) which is fixed to the front end of the dielectric body (30) and is arranged to have the same diameter as the dielectric body (30) ; and a second ground electrode (42, 72, 82) connected to the rear end of the dielectric body (30) towards the vacuum pump (20); the
at least one driving electrode (50) fixed to an outer peripheral surface of the dielectric body, and connected to the AC power supply unit (60, 61, 62, 63, 64) to receive an AC driving voltage, the dielectric body (30) and the driving electrode (50) being formed in the shape of a cylinder or ring having a constant diameter,
wherein the ground electrode is arranged to have a non-uniform diameter along the lengthwise direction of the plasma reactor, and
wherein the first ground electrode (41, 71, 81) is a connecting tube arranged to connect the process chamber (10) and the dielectric body (30), and the second ground electrode (42, 72, 82) is a connecting tube arranged to connect the dielectric body (30) and the vacuum pump (20), and
wherein the second ground electrode, comprises:
a variable diameter portion (721), which is fixed to the rear end of the dielectric body (30), and which is arranged such that its diameter gradually decreases along the flow direction of contaminants, and a uniform diameter portion (722) connected to the variable diameter portion and arranged to have a smaller diameter than the dielectric body (30).

2. The plasma reactor of claim 1 arranged such that a first distance (L1) between the driving electrode (50) and the first ground electrode (71) is set larger than a second distance (L2) between the driving electrode (50) and the second ground electrode (72).

3. The plasma reactor of any one of claim 1 to claim 2, wherein the driving electrode (50) is disposed in an annular shape or a cylindrical shape on an outer peripheral surface of the dielectric body (30), and
the driving electrode (50) is positioned at a distance from the first ground electrode and the second ground electrode along the lengthwise direction of the plasma reactor.

4. The plasma reactor of any one of claim 1 to claim 2, wherein the driving electrode (50) comprises a first driving electrode (51) and a second driving electrode (52) that are disposed in an annular shape or a cylindrical shape on an outer peripheral surface of the dielectric body (30) and positioned at a distance from each other, and
the first driving electrode (51) and the second driving electrode (52) are respectively positioned at a distance from the first ground electrode and the second ground electrode along the lengthwise direction of the plasma reactor.

5. The plasma reactor of any one of claims 1 to 4, wherein the dielectric body (30) comprises a first dielectric body (31) and a second dielectric body (32) that are positioned at a distance from each other, and
the ground electrode comprises a third ground electrode (43) positioned between the first dielectric body (31) and the second dielectric body (32) and arranged to have having a non-uniform diameter.

6. The plasma reactor of claim 5, wherein the third ground electrode (43) comprises:
a first variable diameter portion (431), which is fixed to the rear end of the first dielectric body (31) and which is arranged such that its diameter gradually decreases along the flow direction of contaminants; and
a second variable diameter portion (432), which is arranged such that its diameter gradually increases along the flow direction of contaminants and which is fixed to the front end of the second dielectric body (32).

7. The plasma reactor of claim 6, wherein the first variable diameter portion (431) and the second variable diameter portion (432) are varied in diameter at a fixed ratio, or have a staircase-like stepped part.

8. The plasma reactor of any one of claims 5 to 7, wherein the ground electrode comprises:
a fourth ground electrode (44) positioned at the front end of the first dielectric body (31) and arranged to connect the process chamber (10) and the first dielectric body (31); and
a fifth ground electrode (45) positioned at the rear end of the second dielectric body (32) and arranged to connect the second dielectric body (32) and the vacuum pump (20).

9. The plasma reactor of claim 8, wherein the fourth ground electrode (44) and/or the fifth ground electrode (45), respectively, comprises:
a uniform diameter portion (441, 452) arranged to have a smaller diameter than the first dielectric body (31), respectively than the second dielectric body (32); and
a variable diameter portion (442, 451), which is fixed to the front end of the first dielectric body (31), respectively to the rear end of the second dielectric body (32), and which is arranged such that its diameter gradually increases, respectively decreases, along the flow direction of contaminants.

10. The plasma reactor of any one of claims 7 to 9, wherein the driving electrode comprises:
a third driving electrode (53) disposed in an annular shape or a cylindrical shape on an outer peripheral surface of the first dielectric body (31); and
a fourth driving electrode (54) disposed in an annular shape or a cylindrical shape on an outer peripheral surface of the second dielectric body (32).

11. The plasma reactor of claim 10, wherein the third driving electrode (53) and the fourth driving electrode (54) are arranged to receive bipolar pulse voltages having
the same level and the same polarity or opposite polarities.

## Patentansprüche

1. Plasmareaktor zum Entfernen von Schadstoffen, um zwischen einer Prozesskammer (10) und einer Vakuumpumpe (20) positioniert zu werden, und ausgestaltet, um Niederdruckplasma zu erzeugen, um Schadstoffe, die aus der Prozesskammer (10) emittiert werden zu entfernen, wobei der Plasmareaktor (300, 310, 320, 330, 340, 350, 360) umfasst:
eine Wechselstrom-Zuführeinheit (60, 61, 62, 63, 64);
mindestens einen dielektrischen Körper (30), der ausgestaltet ist, um einen Plasmaerzeugungsraum darin zu bilden; wobei der dielektrische Körper in der Mitte des Plasmareaktors angeordnet ist;
eine Massenelektrode, umfassend eine erste Massenelektrode (41, 71, 81), die am vorderen Ende des dielektrischen Körpers (30) fixiert ist und ausgestaltet ist, um denselben Durchmesser aufzuweisen, wie der dielektrische Körper (30); und eine zweite Massenelektrode (42, 72, 82), die mit dem hinteren Ende des dielektrischen Körpers (30) in Richtung Vakuumpumpe (20) verbunden ist;
mindestens eine Treiberelektrode (50), die an einer äußeren umlaufenden Oberfläche des dielektrischen Körpers fixiert ist und mit der Wechselstrom-Zuführeinheit (60, 61, 62, 63, 64) verbunden ist, um eine Treiberwechselspannung zu empfangen, wobei der dielektrische Körper (30) und die Treiberelektrode (50) in der Form eines Zylinders oder Ringes ausgeformt sind, der einen konstanten Durchmesser aufweist,
wobei die Massenelektrode ausgestaltet ist, um einen nicht einheitlichen Durchmesser entlang der Längsrichtung des Plasmareaktors aufzuweisen, und
wobei die erste Massenelektrode (41, 71, 81)ein Verbindungsrohr ist, das ausgestaltet ist, um die Prozesskammer (10) und den dielektrischen Körper (30) zu verbinden, und die zweite Massenelektrode (42, 72, 82) ein Verbindungsrohr ist, das ausgestaltet ist, um den dielektrischen Körper (30) und die Vakuumpumpe (20) zu verbinden, und
wobei die zweite Massenelektrode umfasst:
einen Abschnitt mit variablem Durchmesser (721), der an dem hinteren Ende des dielektrischen Körpers (30) fixiert ist, und der ausgestaltet ist, sodass sein Durchmesser entlang der Strömungsrichtung der Schadstoffe schrittweise abnimmt, und einen Abschnitt mit einheitlichem Durchmesser (722), der mit dem Abschnitt mit variablem Durchmesser verbunden und ausgestaltet ist, um einen kleineren Durchmesser als der dielektrische Körper (30) aufzuweisen.

2. Plasmareaktor nach Anspruch 1, so ausgestaltet, dass ein erster Abstand (L1) zwischen der Treiberelektrode (50) und der ersten Massenelektrode (71) größer eingestellt ist, als ein zweiter Abstand (L2) zwischen der Treiberelektrode (50) und der zweiten Massenelektrode (72).

3. Plasmareaktor nach einem von Anspruch 1 bis Anspruch 2, wobei die Treiberelektrode (50) in einer ringförmigen Form oder einer zylindrischen Form auf einer äußeren umlaufenden Oberfläche des dielektrischen Körpers (30) angeordnet ist, und
die Treiberelektrode (50) in einem Abstand von der ersten Massenelektrode und der zweiten Massenelektrode entlang der Längsrichtung des Plasmareaktors positioniert ist.

4. Plasmareaktor nach einem der Ansprüche 1 bis Anspruch 2, wobei die Treiberelektrode (50) eine erste Treiberelektrode (51) und eine zweite Treiberelektrode (52) umfasst, die in einer ringförmigen Form oder einer zylindrischen Form auf einer äußeren umlaufenden Oberfläche des dielektrischen Körpers (30) angeordnet sind, und in einem Abstand voneinander positioniert sind, und
die erste Treiberelektrode (51) und die zweite Treiberelektrode (52) jeweils in einem Abstand von der ersten Massenelektrode und der zweiten Massenelektrode entlang der Längsrichtung des Plasmareaktors positioniert sind.

5. Plasmareaktor nach einem der Ansprüche 1 bis 4, wobei der dielektrische Körper (30) einen ersten dielektrischen Körper (31) und einen zweiten dielektrischen Körper (32) umfasst, die in einem Abstand voneinander positioniert sind, und
die Massenelektrode eine dritte Massenelektrode (43) umfasst, die zwischen dem ersten dielektrischen Körper (31) und dem zweiten dielektrischen Körper (32) positioniert und ausgestaltet ist, um einen nicht einheitlichen Durchmesser aufzuweisen.

6. Plasmareaktor nach Anspruch 5, wobei die dritte Massenelektrode (43) umfasst:
einen ersten Abschnitt mit variablem Durchmesser (431), der am hinteren Ende des ersten dielektrischen Körpers (31) fixiert ist und der so ausgestaltet ist, dass sein Durchmesser entlang der Strömungsrichtung von Schadstoffen schrittweise abnimmt; und
einen zweiten Abschnitt mit variablem Durchmesser (432), der so ausgestaltet ist, dass sein Durchmesser entlang der Strömungsrichtung von Schadstoffen schrittweise zunimmt und der an dem vorderen Ende des zweiten dielektrischen Körpers (32) fixiert ist.

7. Plasmareaktor nach Anspruch 6, wobei der erste Abschnitt mit variablem Durchmesser (431) und der zweite Abschnitt mit variablem Durchmesser (432) im Durchmesser mit einem fixen Verhältnis variieren, oder einen treppenförmigen abgestuften Teil aufweisen.

8. Plasmareaktor nach einem der Ansprüche 5 bis 7, wobei die Massenelektrode umfasst:
eine vierte Massenelektrode (44), die an dem vorderen Ende des ersten dielektrischen Körpers (31) positioniert und ausgestaltet ist, um die Prozesskammer (10) und den ersten dielektrischen Körper (31) zu verbinden; und
eine fünfte Massenelektrode (45), die an dem hinteren Ende des zweiten dielektrischen Körpers (32) positioniert und ausgestaltet ist, um den zweiten dielektrischen Körper (32) und die Vakuumpumpe (20) zu verbinden.

9. Plasmareaktor nach Anspruch 8, wobei die vierte Massenelektrode (44) und/oder die fünfte Massenelektrode (45) jeweils umfasst:
einen Abschnitt mit einem einheitlichen Durchmesser (441, 452), der ausgestaltet ist, um einen kleineren Durchmesser aufzuweisen, als der erste dielektrische Körper (31), beziehungsweise als der zweite dielektrische Körper (32); und
einen Abschnitt mit einem variablen Durchmesser (442, 451), der an dem vorderen Ende des ersten dielektrischen Körpers (31), beziehungsweise an dem hinteren Ende des zweiten dielektrischen Körpers (32) fixiert ist und der so ausgestaltet ist, dass sein Durchmesser entlang der Strömungsrichtung von Schadstoffen schrittweise zunimmt, beziehungsweise abnimmt.

10. Plasmareaktor nach einem der Ansprüche 7 bis 9, wobei die Treiberelektrode umfasst:
eine dritte Treiberelektrode (53), die in einer ringförmigen Form oder einer zylindrischen Form an einer äußeren umlaufenden Oberfläche des ersten dielektrischen Körpers (31) angeordnet ist; und
eine vierte Treiberelektrode (54), die in einer ringförmigen Form oder einer zylindrischen Form an einer äußeren umlaufenden Oberfläche des zweiten dielektrischen Körpers (32) angeordnet ist.

11. Plasmareaktor nach Anspruch 10, wobei die dritte Treiberelektrode (53) und die vierte Treiberelektrode (54) ausgestaltet sind, um bipolare Impulsspannungen zu empfangen, die dasselbe Niveau und dieselbe Polarität oder entgegengesetzte Polaritäten aufweisen.

## Revendications

1. Réacteur à plasma pour l'élimination de contaminants, pour être positionné entre une chambre de traitement (10) et une pompe à vide (20), et agencé pour générer un plasma à basse pression pour l'élimination de contaminants émis par la chambre de traitement (10), le réacteur à plasma (300, 310, 320, 330, 340, 350, 360) comprenant :
une unité d'alimentation électrique en courant alternatif (60, 61, 62, 63, 64) ;
au moins un corps diélectrique (30) agencé pour former un espace de génération de plasma à l'intérieur de celui-ci ; le corps diélectrique étant disposé au centre du réacteur à plasma ;
une électrode de masse comprenant une première électrode de masse (41, 71, 81) qui est fixée à l'extrémité avant du corps diélectrique (30) et est agencée pour avoir le même diamètre que le corps diélectrique (30) ; et une deuxième électrode de masse (42, 72, 82) reliée à l'extrémité arrière du corps diélectrique (30) en direction de la pompe à vide (20) ;
au moins une électrode d'attaque (50) fixée à une surface périphérique extérieure du corps diélectrique, et reliée à l'unité d'alimentation électrique en courant alternatif (60, 61, 62, 63, 64) pour recevoir une tension d'attaque en courant alternatif, le corps diélectrique (30) et l'électrode d'attaque (50) se présentant sous la forme d'un cylindre ou d'un anneau ayant un diamètre constant,
dans lequel l'électrode de masse est agencée pour avoir un diamètre non uniforme le long de la direction longitudinale du réacteur à plasma, et
dans lequel la première électrode de masse (41, 71, 81) est un tube de liaison agencé pour relier la chambre de traitement (10) et le corps diélectrique (30), et la deuxième électrode de masse (42, 72, 82) est un tube de liaison agencé pour relier le corps diélectrique (30) et la pompe à vide (20), et
dans lequel la deuxième électrode de masse, comprend :
une partie de diamètre variable (721) qui est fixée à l'extrémité arrière du corps diélectrique (30), et qui est agencée de sorte que son diamètre diminue progressivement le long de la direction d'écoulement de contaminants, et une partie de diamètre uniforme (722) reliée à la partie de diamètre variable et agencée pour avoir un diamètre plus petit que celui du corps diélectrique (30).

2. Réacteur à plasma de la revendication 1 agencé de sorte qu'une première distance (L1) entre l'électrode d'attaque (50) et la première électrode de masse (71) soit établie de manière à être supérieure à une deuxième distance (L2) entre l'électrode d'attaque (50) et la deuxième électrode de masse (72).

3. Réacteur à plasma de l'une quelconque des revendications 1 et 2, dans lequel l'électrode d'attaque (50) est disposée selon une forme annulaire ou une forme cylindrique sur une surface périphérique extérieure du corps diélectrique (30), et
l'électrode d'attaque (50) est positionnée à une certaine distance de la première électrode de masse et de la deuxième électrode de masse le long de la direction longitudinale du réacteur à plasma.

4. Réacteur à plasma de l'une quelconque des revendications 1 et 2, dans lequel l'électrode d'attaque (50) comprend une première électrode d'attaque (51) et une deuxième électrode d'attaque (52) qui sont disposées selon une forme annulaire ou une forme cylindrique sur une surface périphérique extérieure du corps diélectrique (30) et qui sont positionnées à une certaine distance l'une de l'autre, et
la première électrode d'attaque (51) et la deuxième électrode d'attaque (52) sont respectivement positionnées à une certaine distance de la première électrode de masse et de la deuxième électrode de masse le long de la direction longitudinale du réacteur à plasma.

5. Réacteur à plasma de l'une quelconque des revendications 1 à 4, dans lequel le corps diélectrique (30) comprend un premier corps diélectrique (31) et un deuxième corps diélectrique (32) qui sont positionnés à une certaine distance l'un de l'autre, et
l'électrode de masse comprend une troisième électrode de masse (43) positionnée entre le premier corps diélectrique (31) et le deuxième corps diélectrique (32) et agencée pour avoir un diamètre non uniforme.

6. Réacteur à plasma de la revendication 5, dans lequel la troisième électrode de masse (43) comprend :
une première partie de diamètre variable (431), qui est fixée à l'extrémité arrière du premier corps diélectrique (31) et qui est agencée de sorte que son diamètre diminue progressivement le long de la direction d'écoulement de contaminants ; et
une deuxième partie de diamètre variable (432), qui est agencée de sorte que son diamètre augmente progressivement le long de la direction d'écoulement de contaminants et qui est fixée à l'extrémité avant du deuxième corps diélectrique (32).

7. Réacteur à plasma de la revendication 6, dans lequel la première partie de diamètre variable (431) et la deuxième partie de diamètre variable (432) ont un diamètre variable selon un rapport fixe, ou ont une partie étagée en forme d'escalier.

8. Réacteur à plasma de l'une quelconque des revendications 5 à 7, dans lequel l'électrode de masse comprend :
une quatrième électrode de masse (44) positionnée au niveau de l'extrémité avant du premier corps diélectrique (31) et agencée pour relier la chambre de traitement (10) et le premier corps diélectrique (31) ; et
une cinquième électrode de masse (45) positionnée au niveau de l'extrémité arrière du deuxième corps diélectrique (32) et agencée pour relier le deuxième corps diélectrique (32) et la pompe à vide (20).

9. Réacteur à plasma de la revendication 8, dans lequel la quatrième électrode de masse (44) et/ou la cinquième électrode de masse (45) comprend/comprennent respectivement :
une partie de diamètre uniforme (441, 452) agencée pour avoir un diamètre plus petit que celui du premier corps diélectrique (31), respectivement, que celui du deuxième corps diélectrique (32) ; et
une partie de diamètre variable (442, 451), qui est fixée à l'extrémité avant du premier corps diélectrique (31), respectivement à l'extrémité arrière du deuxième corps diélectrique (32) et qui est agencée de sorte que son diamètre augmente progressivement, diminue respectivement, le long de la direction d'écoulement de contaminants.

10. Réacteur à plasma de l'une quelconque des revendications 7 à 9, dans lequel l'électrode d'attaque comprend :
une troisième électrode d'attaque (53) disposée selon une forme annulaire ou une forme cylindrique sur une surface périphérique extérieure du premier corps diélectrique (31) ; et
une quatrième électrode d'attaque (54) disposée selon une forme annulaire ou une forme cylindrique sur une surface périphérique extérieure du deuxième corps diélectrique (32).

11. Réacteur à plasma de la revendication 10, dans lequel la troisième électrode d'attaque (53) et la quatrième électrode d'attaque (54) sont agencées pour recevoir des tensions d'impulsions bipolaires ayant le même niveau et la même polarité ou des polarités opposées.
